(19) **Europäisches Patentamt / European Patent Office / Office européen des brevets**

(11) **EP 1 480 195 B1**

(12) **EUROPEAN PATENT SPECIFICATION**

(45) Date of publication and mention
of the grant of the patent:
**07.05.2008 Bulletin 2008/19**

(51) Int Cl.:
***G09G 3/32*** (2006.01)

(21) Application number: **03076597.8**

(22) Date of filing: **23.05.2003**

(54) **Method of displaying images on a large-screen organic light-emitting diode display, and display used therefore**

Verfahren zur Anzeige von Bildern auf einer Grossbildschirmanzeige aus organischen Leuchtdioden sowie die dazu verwendete Anzeige

Procédé d'affichage d'images sur un grand écran d'affichage à diodes organique luminescentes et l'afficheur utilisé à cet effet

(84) Designated Contracting States:
**AT BE BG CH CY CZ DE DK EE ES FI FR GB GR HU IE IT LI LU MC NL PT RO SE SI SK TR**

(43) Date of publication of application:
**24.11.2004 Bulletin 2004/48**

(60) Divisional application:
**07075284.5 / 1 814 100**

(73) Proprietor: **BARCO N.V.**
**8500 Kortrijk (BE)**

(72) Inventors:
• **Tanghe Gino**
**8650 Merkem (BE)**
• **Willem Patrick**
**8400 Oostende (BE)**
• **Thielemans Robbie**
**9810 Nazareth (BE)**

(74) Representative: **Donné, Eddy**
**Bureau M.F.J. Bockstael nv**
**Arenbergstraat 13**
**2000 Antwerpen (BE)**

(56) References cited:
| | |
|---|---|
| EP-A- 1 187 212 | EP-A- 1 225 557 |
| EP-A- 1 227 466 | EP-A- 1 260 959 |
| WO-A-00/65432 | WO-A-01/63587 |
| WO-A-02/47310 | WO-A-03/019510 |
| DE-A- 10 138 004 | DE-A- 19 950 839 |
| US-A- 4 833 542 | US-A- 5 796 376 |
| US-A- 6 097 351 | US-A1- 2002 033 783 |
| US-A1- 2003 071 804 | US-B1- 6 337 542 |
| US-B1- 6 498 592 | |

**Description**

FIELD OF THE INVENTION

The present invention relates to a method for displaying images on a large-screen organic light-emitting diode (OLED) display, as well as to a display used therefore, and more particularly to a modular large-screen OLED display. Still more particularly, this invention relates to drive circuitry control for improved display picture quality.

BACKGROUND OF THE INVENTION

OLED technology incorporates organic luminescent materials that, when sandwiched between electrodes and subjected to a DC electric current, produce intense light of a variety of colors. These OLED structures can be combined into the picture elements, or pixels, that comprise a display. OLEDs are also useful in a variety of applications as discrete light-emitting devices or as the active element of light-emitting arrays or displays, such as flat-panel displays in watches, telephones, laptop computers, pagers, cellular phones, calculators and the like. To date, the use of light-emitting arrays or displays has been largely limited to small-screen applications such as those mentioned above.

The market is now, however, demanding larger displays with the flexibility to customize display sizes. For example, advertisers use standard sizes for marketing materials; however, those sizes differ based on location. Therefore, a standard display size for the United Kingdom differs from that of Canada or Australia. Additionally, advertisers at trade shows need bright, eye-catching, flexible systems that are easily portable and easy to assemble/disassemble. Still another rising market for customizable large display systems is the control room industry, where maximum display quantity, quality, and viewing angles are critical. Demands for large-screen display applications possessing higher quality and higher light output has led the industry to turn to alternative display technologies that replace older LED and liquid crystal displays (LCDs). For example, LCDs fail to provide the bright, high light output, larger viewing angles, and high resolution and speed requirements that the large-screen display market demands. By contrast, OLED technology promises bright, vivid colors in high resolution and at wider viewing angles. However, the use of OLED technology in large-screen display applications, such as outdoor or indoor stadium displays, large marketing advertisement displays, and mass-public informational displays, is only beginning to emerge.

Several technical challenges exist relating to the use of OLED technology in a large-screen application. One such challenge is that OLED displays are required to offer a wide dynamic range of colors, contrast and light intensity depending on various external environmental factors including ambient light, humidity and temperature. For example, outdoor displays are required to produce more white color contrast during the day and more black color contrast at night. Additionally, light output must be greater in bright sunlight and lower during darker, inclement weather conditions. Additionally, temperature increases of as little as 10 degrees may cause a severe change in the output of red colour OLEDs. Furthermore, the same temperature increase may cause an increase in light output for blue and green OLEDs. However, the intensity of the light emission produced by an OLED device is also directly dependent on the amount of current driving the device. Therefore, the more light output needed, the more current is fed to the pixel. Accordingly, less light emission is achieved by limiting the current to the OLED device. Thus for the various light output requirements mentioned above, controlled changes to the associated current drivers produces the desired results.

Larger displays also suffer from lower manufacturing yields. The larger the display, the more pixels it contains and the more likely it is that one or more pixels will not work properly and, moreover, cannot be reworked; thus, the entire display must be scrapped.

In order to solve this problem, it is known to use modular displays, for example as described in WO 00/65432, which are composed of smaller tile-shaped displays. Hereby each of the display tiles are manufactured as a complete unit that can be further combined with other tiles to create displays of any size and shape. By using tiled displays, tiles that have become too old to operate efficiently or are no longer functioning properly may be easily replaced with a new tile.

Although the invention which is described in WO 00/65432 can be applied in connection with all kinds of display devices, thus including LED display devices as well as OLED display devices, in order to further optimize the function of such display device, especially when using OLEDs, it is useful to generate more processing capabilities, especially in order to allow to create an higher quality picture.

A further example of a display driver system and method of operation for a large-screen modular display is described in international patent application WO 99/41732. This patent application describes a tiled display device that is formed from display tiles having pixel positions defined up to the edge of the tiles. Each pixel position has an OLED active area, which occupies approximately twenty-five percent of the pixel area. Each tile includes a memory, which stores display data, and pixel driving circuitry, which controls the scanning and illumination of the pixels on the tile. The pixel driving circuitry is located on the back side of the tile and connections to pixel electrodes on the front side of the tile are made by vias that pass through portions of selected ones of the pixel areas that are not occupied by the active pixel material. The tiles are formed in two parts - an electronics section and a display section. Each of these parts includes connecting pads, which cover several pixel positions. Each connecting pad makes an electrical connection to only one row electrode or column electrode. The connecting pads on the display section are electrically connected and physically joined to corresponding connecting pads on the electronics section to form a complete tile. Each tile has a glass substrate on the front of the tile. Black matrix lines are formed on the front of the glass substrate and the tiles are joined by mullions, which have the same appearance as the black matrix lines. Alternatively, the black matrix lines may be formed on the inside surface of an optical integrating plate and the tiles may be affixed to the integrating plate such that the edges of the joined tiles are covered by the black matrix lines. A cathodoluminescent tile structure is formed from individual tiles that have multiple phosphor areas, a single emissive cathode, and horizontal and vertical electrostatic deflecting grids, which deflect the electron beam, produced by the single cathode onto multiple ones of the phosphor areas.

Although the structure described in WO 99/41732 provides a means for interconnecting tiles to create a large display system, it fails to provide a system for and method of controlling the electronic circuitry in order to maximize brightness and contrast based on ambient light and temperature information. The structure described in this patent application also fails to provide a system for or method of compensating for varied light output on a pixel-by-pixel basis due to age, "on" time, and current densities through each pixel during on time. Furthermore, the structure also fails to provide a system for or method of color correction when older modules are replaced by newer modules, nor does it provide a means for random line addressability for enhanced picture quality.

US 4833542 describes a large screen display apparatus, comprising a display unit, composed of a plurality of modules and a housing accomodating the display unit. Each of the modules includes a plurality of units, arranged in a matrix form, a power source and a control unit. Further, each of the units includes a plurality of light emitting elements. Due to this arrangement, it is possible to provide a large screen display apparatus being economical, small in weight and volume and high in usability.

US 5796376 describes an electronic display sign constructed around a system bus architecture. The electronic display sign is preferably a modular construction wherein a number of modules connected together to form a large display sign which is capable of displaying images at rates which exceed thirty frames a second. Display data is formatted and transmitted to display modules by a sign controller which resides on one of the panels. Each display panel is preferably provided with its own power source.

The American patent No. 6498592 describes a tiled display structure that is fabricated on a single substrate that also serves as a circuit board containing electronic components. Electrode are formed on the substrate and the remainder of the display section is formed on the electrodes. The pixel elements use patterned display, and occupy only a portion of the pixel structure. The electronic components are mounted on the substrate, using exceptionally long leads to assist in thermal management of tiles. Alternatively, each tile includes a fin structure on the circuit board surface onto which electronic components are mounted and are not in contact with the substrate. Alternatively, each tile includes a flexible circuit board, mounted on the substrate, a portion of which is bent away from the substrate. Electronic components are coupled to this portion of the flexible circuit boards such that the components are not in contact with the substrate to assist in thermal management.

German patent No. 199 50 839 describes display elements that are arranged in lines and columns. A seperate control circuit handles each one of multiple subarrays in an array of display elements formed as a line or a column by multiple display elements. A first linking structure links each control circuit to the display elements for an allocated subarray. An independent claim is included for a method for producing a display device.

SUMMARY OF THE INVENTION

It is therefore an object of the invention to provide a system for and method of driving OLED modules in a large-screen tiled display with more processing capabilities than conventional systems, in particular with color adjustment capabilities.

It is another object of this invention to provide a system for and method of driving OLED modules in a large-screen tiled display that yields a higher quality picture than conventional systems.

It is yet another object of this invention to provide a system for and method of driving OLED modules in a large-screen tiled display with more control over and flexibility of the light output of each pixel than conventional systems.

It is yet another object of this invention to provide a system for and method of driving OLED modules in a large-screen tiled display that possesses randomly addressable line characteristics.

The invention is set forth in the attached claims 1 and 16.

To this end, the present invention, in first instance, provides a method for displaying images on a large-screen organic light-emitting diode display, wherein use is made of an organic light-emitting diode (OLED) display comprising an array of OLED display tiles that are each formed of an array of smaller OLED display modules, each OLED display module comprising a number of OLED pixels, wherein each OLED display module includes an intelligent OLED module processing system, whereby, in order to display the images, data concerning the image to be displayed, provided by a general processing unit, in other words a system controller, are transmitted to tile processing systems and from each tile processing system towards the respective modules, the method being characterized in that in use color measurements are taken, and in that in each OLED module processing system (210) the amount of time is determined that has been elapsed since the last color measurements were taken, whereby this time is compared with a set value, whereby in case that this time is longer than said set value, a new measurement is carried out.

By using a tiled display, the tiles of which are further composed of modules which each include an intelligent OLED module processing system, more processing capabilities than in the existing systems can be created. Moreover, data can quickly be transmitted in a serial manner to the different tile processing systems, whereas these systems can parse the data further towards the module processing systems.

Preferably, the method is further characterized in that the general processing unit provides RGB data and control (CNTL) data, whereby data from the RGB data are collected at each individual tile processing system and/or module processing system as a function of control signals generated by means of said control (CNTL) data. In this way, each processing system can work to a certain extent independently, resulting in that less data transmission is required and calculation time as well as calculation capacity become available.

Further, in a preferred embodiment, said OLED module processing systems make decisions regarding the amount of current to use when driving each OLED pixel in a module.

Preferably, with regard to the drive of the OLED pixels, one or more adjustments are made at the corresponding tile processing system and/or at the corresponding module processing system itself.

Further, the present invention also relates to a large-screen organic light-emitting diode display, more particularly for realizing the method of the invention, whereby this display comprises an array of OLED display tiles that are each formed of an array of smaller OLED display modules, wherein each OLED display module includes at least one intelligent OLED module processing system, and whereby each tile (140) comprises a tile processing system (220), coupled to the respective modules (130) and in communication with each of the OLED module processing systems (220) and the OLED module processing systems (210) comprise electronic configured so as to carry out the method of any of the claims 1 to 15, characterized in that it is configured such that the size and dimension can be changed by adding or removing tiles.

Of course, the invention also relates to large screen organic light-emitting diode displays, more particularly for realizing the method of the invention, whereby this display (100) comprises an array of OLED display tiles (140) that are each formed of an array of smaller OLED display modules (130), wherein each OLED display module (130) includes at least one intelligent OLED module processing system (210), and whereby each tile (140) comprises a tile processing system (220), coupled to the respective modules (130) and in communication with each of the OLED module processing systems (220) and the OLED module processing systems (210) comprise electronic configured so as to carry out the method of any of the claims 1 to 15, characterized in that it is configured such that the modules are replaceable.

Finally, it should be noted that the small modules have much higher yields than for example the larger tiles and consequently also offer much greater flexibility.

BRIEF DESCRIPTION OF THE DRAWINGS

With the intention of better showing the characteristics of the invention, hereafter, as example without any limitative character, some preferred forms of embodiment are described, with reference to the accompanying drawings, wherein:

Figure 1 is a diagram of a large-screen OLED display illustrating a modular architecture in accordance with the invention;

Figure 2 illustrates a functional block diagram of an OLED tile suitable for use in a large-screen OLED display in accordance with the invention;

Figure 3 illustrates a functional block diagram of an OLED module processing system suitable for use in a large-screen OLED display in accordance with the invention;

Figure 4 illustrates a schematic diagram of OLED circuitry, which is representative of a portion of a typical common-anode, passive-matrix, large-screen OLED array;

Figure 5 shows a diagram of the gamma correction function in accordance with the invention;

Figure 6 is a flow diagram of a method of operating a module in accordance with the invention;

Figure 7 is a flow diagram of an alternative method of operating a module in accordance with the invention.

DETAILED DESCRIPTION OF PREFERRED EMBODIMENTS

The present invention is a modular, scalable large-screen OLED display system and methods of using the system. More specifically, the OLED display system of the present invention is formed of an array of smaller OLED display tile units that are each formed of an array of yet smaller OLED display module units. Under the control of a system controller, each OLED display module includes intelligent OLED module processing systems that use data collection devices and algorithms to make decisions regarding the amount of current to use when driving each OLED pixel in a module. In operation; the large-screen OLED display system of the present invention monitors and records the time each individual pixel is on and, furthermore, how much current was used to drive each OLED during that "on" time. The large-screen OLED display system of the present invention uses this information along with data from the system controller to determine the age and relative brightness of each pixel, thus maximizing the overall display quality by accounting for such factors as age, temperature, color contrast, and gamma value. Furthermore, the large-screen OLED display system of the present invention processes all of the data and compensates for each pixel based on its condition, thus maximizing the overall picture quality for that particular module at any given time.

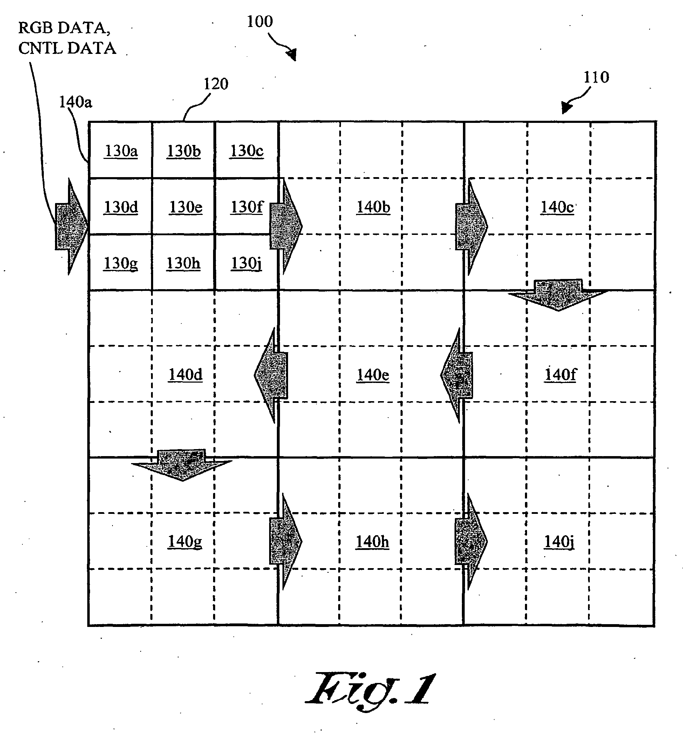

Figure 1 is a diagram of a large-screen OLED display 100 illustrating a modular architecture in accordance with the invention. Large-screen OLED display 100 includes a tile array 110 that includes a plurality of tiles 140, e.g., a tile 140a through 140j forming a 3x3 array. Each tile 140 further includes a module array 120, which includes a plurality of modules 130, e.g., a module 130a through 130j forming a yet smaller a 3x3 array. In general, the 9x9 arrangements shown in figure 1 are simply illustrative in nature, OLED display 100 may include any number of tiles 140 and, similarly, a tile 140 may include any number of modules 130.

Red, green, blue (RGB) DATA is a serial data signal containing the current video frame information to be displayed on OLED display 100. The serial RGB DATA signal of tiles 140 is daisy-chained such that it is fed first into tile 140a and is subsequently repowered and relayed to tile 140b. Tile 140b subsequently transmits the reamplified RGB DATA signal to tile 140c. Subsequently tile 140c transmits the reamplified RGB DATA signal to tile 140f and so forth until the last tile, tile 140j in this example, receives the current video frame of RGB DATA. In this manner, all tiles 140 receive the RGB DATA that describes the current video frame. In general, tiles 140 are not limited to the daisy-chain structure and order of distribution shown in this example. Any well-known wiring distribution methods may be used for distributing RGB DATA to all tiles 140.

Additionally, control data from a general processor (not shown) that functions as the system-level controller of OLED display 100, such as a personal computer (PC), is supplied to OLED display 100 via a control data bus, hereafter called CNTL DATA bus. The CNTL DATA bus is a serial data bus that provides control information to OLED display 100, such as color temperature, gamma, and imaging information for each tile 140 within OLED display 100. The CNTL DATA bus of tiles 140 is daisy-chained as described above in reference to the serial RGB DATA signal.

Furthermore, OLED display 100 is customizable to any size and dimension by adding or removing tiles 140 to achieve the desired display structure. Additionally; OLED display 100 is also maintainable and repairable due to its modularity. For example, a module 130 that does not function properly or contains failed pixels may be replaced with another module 130 by removing the non-functional module 130 and inserting a new module 130 into the backplane of its corresponding tile 140. By contrast, large contiguous display systems must be replaced in their entirety when portions of the display malfunction or pixels go dark. Therefore, the modular display provides a longer display life and has lower replacement costs than conventional large single-unit displays.

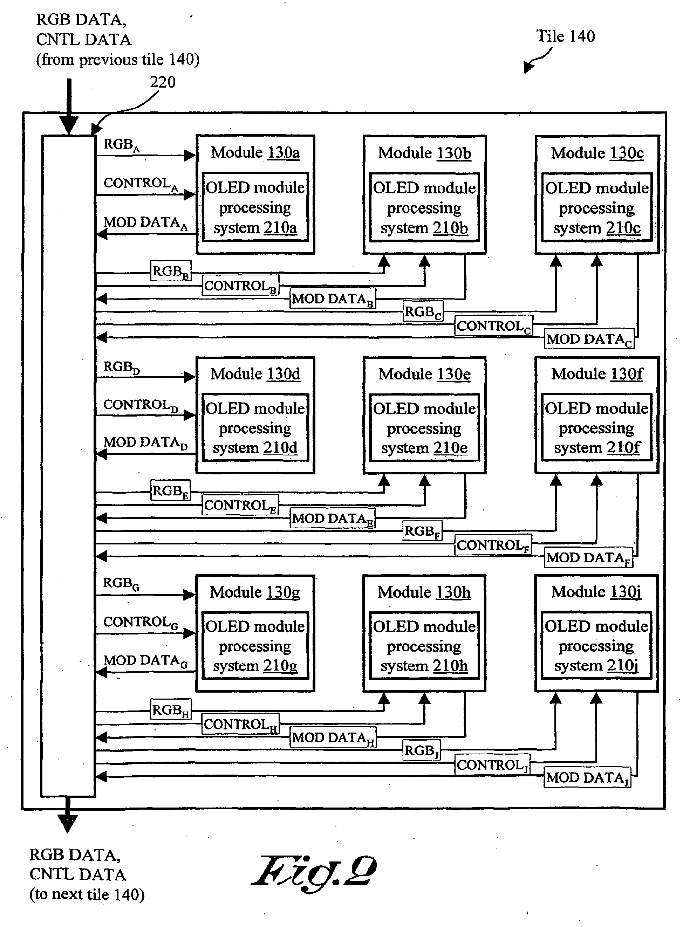

Figure 2 illustrates a functional block diagram of an OLED tile 140 suitable for use in large-screen OLED display 100 in accordance with the invention. OLED tile 140 includes a tile processing system 220 and the plurality of modules 130, i.e., modules 130a through 130j. Each module 130 further includes an OLED module processing system 210, i.e., modules 130a through 130j include OLED module processing systems 210a through 210j, respectively. The RGB DATA signal and the CNTL DATA bus are provided as inputs to tile processing system 220. Tile processing system 220 amplifies the RGB DATA signal and the CNTL DATA bus for transmission to the next tile 140, as shown in figure 2.

Using the imaging information from the CNTL DATA bus, each tile processing system 220 stores the serial RGB DATA for that particular frame that corresponds to its physical position within OLED display 100. For example and with reference to figures 1 and 2, tile processing system 220 of tile 140a stores RGB DATA of the current frame corresponding to the upper leftmost corner of OLED display 100, tile processing system 220 of tile 140b stores RGB DATA of the current frame corresponding to the middle and uppermost section of OLED display 100, tile processing system 220 of tile 140j stores RGB DATA of the current frame corresponding to the lower rightmost corner of OLED display 100, and so forth throughout OLED display 100. This process is fully described in WO 00/65432. For clarity, the following description of this patent application is provided. The invention describes a method of displaying images on a display device that includes at least a general processing unit, a display including several display units, and an individual processing unit per display. In order to display the images, data concerning the image to be displayed is transmitted from the general processing unit to the individual processing units in the form of a data stream. There is a control communication between the general processing unit and each of the individual processing units in the form of control signals. The data from the data stream is collected at every individual processing unit as a function of the control signals transmitted to the individual processing units.

Tile processing system 220 receives the RGB DATA signal and subsequently parses this information into specific packets associated with OLED module processing systems 210a through 210j. Subsequently, an $RGB_{(x)}$ signal is generated to each OLED module processing system 210. For example, $RGB_A$ through $RGB_J$ signals are distributed to OLED module processing systems 210a through 210j, respectively. Algorithms running on tile processing system 220 facilitate the process of identifying the portion of the serial RGB DATA input signal that belongs to each subsequent OLED module processing system 210. Subsequently, tile processing system 220 distributes the corresponding serial $RGB_{(x)}$ signal to the corresponding OLED module processing system 210 via its $RGB_{(x)}$ signal.

In similar fashion, tile processing system 220 receives the CNTL DATA bus and subsequently parses this information into specific control buses associated with OLED module processing systems 210a through 210j. Subsequently, a $CONTROL_{(x)}$ bus is generated to each OLED module processing system 210 of each module 130, respectively. For example, $CONTROL_A$ through $CONTROL_J$ buses are distributed to OLED module processing systems 210a through 210j, respectively. The $CONTROL_{(x)}$ buses provide control information, such as color temperature, gamma, and imaging information, to each OLED module processing system 210.

Additionally, tile processing system 220 receives a MODULE $DATA_{(x)}$ bus from each OLED module processing system 210. For example, MODULE $DATA_A$ through MODULE $DATA_J$ buses are received from OLED module processing systems 210a through 210j, respectively. Each OLED module processing system 210 sends critical diagnostic information, such as temperature, aging factors, and other color correction data, to tile processing system 220 via its corresponding MODULE $DATA_{(x)}$ bus.

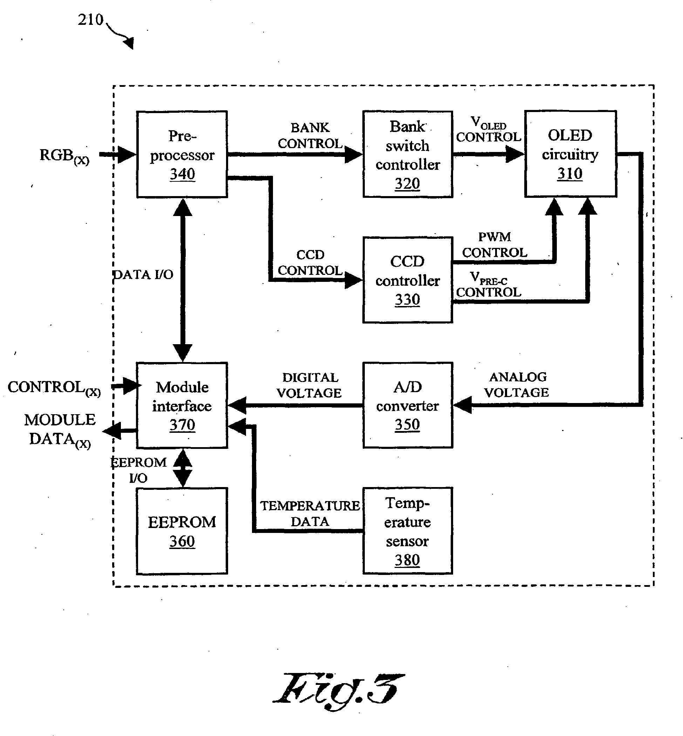

Figure 3 illustrates a functional block diagram of OLED module processing system 210 suitable for use in large-screen OLED display 100 in accordance with the invention. OLED module processing system 210 includes OLED circuitry 310, a bank switch controller 320, a constant current driver (CCD) controller 330, a pre-processor 340, an analog-to-digital (A/D) converter 350, an EEPROM 360, a module interface 370, and a temperature sensor 380.

The elements of OLED module processing system 210 are electrically connected as follows. The $RGB_{(x)}$ signal from tile processing system 220 (figure 2) feeds pre-processor 340; a BANK CONTROL bus output of pre-processor 340 feeds bank switch controller 320; a CCD CONTROL bus output of pre-processor 340 feeds CCD controller 330; a $V_{OLED}$ CONTROL bus output of bank switch controller 320 feeds OLED circuitry 310, a pulse width modulation (PWM) CONTROL bus output of CCD controller 330 feeds OLED circuitry 310; a $V_{PRE-C}$ CONTROL bus output of CCD controller 330 feeds OLED circuitry 310; an ANALOG VOLTAGE bus output of OLED circuitry 310 feeds A/D converter 350; a DIGITAL VOLTAGE bus output of A/D converter 350 feeds module interface 370; a TEMPERATURE DATA bus output of temperature sensor 380 feeds module interface 370; the $CONTROL_{(x)}$ bus output of tile processing system 220 (figure 2) feeds module interface 370; an EEPROM I/O bus exists between EEPROM 360 and module interface 370; a DATA I/O bus exists between pre-processor 340 and module interface 370; and, lastly, module interface 370 drives MODULE $DATA_{(x)}$ bus to tile processing system 220 (figure 2).

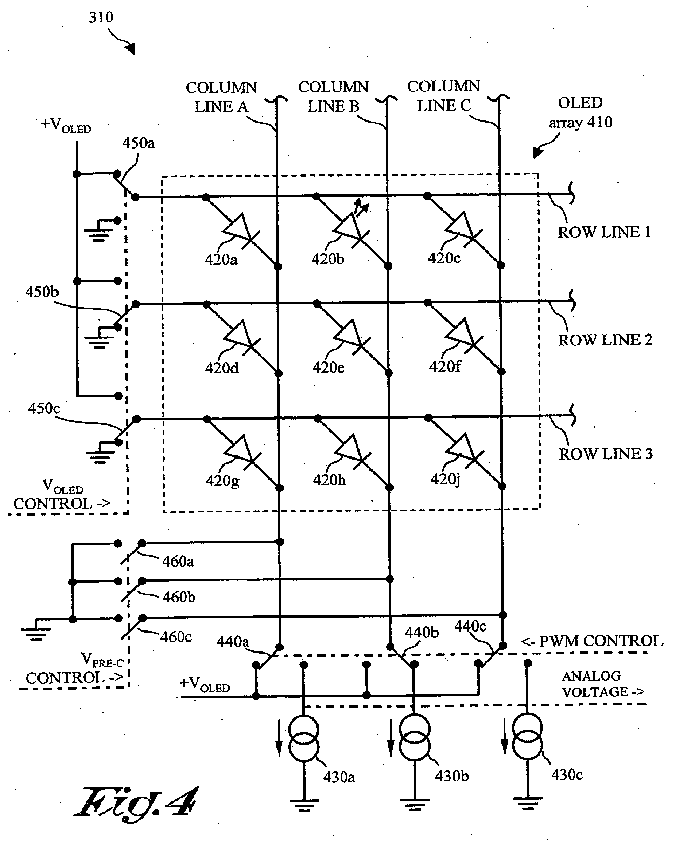

OLED circuitry 310 includes a plurality of OLED devices having associated drive circuitry, which includes positive voltage sources ($+V_{OLED}$), constant current drivers, and several active switches (see figure 4). Those skilled in the art will appreciate that the OLED devices for forming a graphics display are typically arranged in rows and columns to form an OLED array, as is well known. The bank switches connecting the positive voltage sources to the rows of the OLED array within OLED circuitry 310 are controlled by the $V_{OLED}$ CONTROL bus of bank switch controller 320. The active switches connecting the constant current drivers to the columns of the OLED array within OLED circuitry 310 are controlled by the PWM CONTROL bus of CCD controller 330. OLED circuitry 310 also provides feedback of the voltage value across each current source within OLED circuitry 310 via the ANALOG VOLTAGE bus. Further details of OLED circuitry 310 are illustrated in figure 4.

Bank switch controller 320 contains a series of latches (rather than conventional shifters) that store the active state of each bank switch within OLED circuitry 310 for a given frame. In this manner, random line addressing is possible, as opposed to conventional line addressing, which is consecutive. Furthermore, pre-processor 340 may update the values stored within bank switch controller 320 more than once per frame in order to make real-time $+V_{OLED}$ corrections based on temperature and voltage information received during the frame. For example, an increase in temperature during a frame output may trigger a voltage reading command where bank switch controller 320 enables $+V_{OLED}$ to the requested OLED devices. Bank switch controller 320 may be included in an ASIC or in an FPGA.

CCD controller 330 converts data from pre-processor 340 into PWM signals, i.e., PWM CONTROL bus, to drive the current sources that deliver varying amounts of current to the OLED array within OLED circuitry 310. The width of each pulse within PWM CONTROL bus dictates the amount of time a current source associated with a given OLED device will be activated and deliver current. Additionally, CCD controller 330 sends information to each current source regarding the amount of current to drive, which is typically in the range of 5 to 50 mA. The amount of current is determined from the brightness value, Y, calculated in pre-processor 340. Furthermore, the logic controlling the $V_{PRE-C}$ CONTROL bus is included within CCD controller 330. CCD controller 330 may be included in an ASIC or in an FPGA.

Pre-processor 340 develops local color correction, aging correction, black level, and gamma models (gamma correction values may be stored in internal look-up tables, not shown, or in EEPROM 360) for the current video frame using information from module interface 370. Pre-processor 340 combines the RGB data of the RGB$_{(X)}$ signal describing the current frame of video to display with the newly developed color correction algorithms and produces digital control signals, i.e., BANK CONTROL and CCD CONTROL bus, respectively, for bank switch controller 320 and CCD controller 330. These signals dictate exactly which OLED devices within OLED circuitry 310 to illuminate and at what intensity and color temperature in order to produce the desired frame at the required resolution and color-corrected levels. In general, the intensity, or grayscale value, is controlled by the amount of current used to drive an OLED device. Similarly, the color temperature is controlled by the grayscale color value and the relative proximity of each sub-pixel required to produce the desired color. For example, a bright orange color is produced by illuminating a green sub-pixel in close proximity to a brightly lit red sub-pixel. Therefore, it is important to have precise control over the brightness and the amount of time an OLED device is lit.

A/D converter 350 uses the analog voltage values, i.e., ANALOG VOLTAGE bus, from OLED circuitry 310 to feed the voltage information back to module interface 370 via DIGITAL VOLTAGE bus. It is important to monitor voltage thresholds across each OLED device within OLED circuitry 310 so that correct aging factors and light output values may be calculated in order to further produce the correct amounts of driving current through each OLED device within OLED circuitry 310. Pre-processor 340 compares a pre-stored threshold voltage level for each OLED device within OLED circuitry 310 with the measured supply voltage minus the voltage value measured by A/D converter 350 to determine if digital voltage correction is plausible. If the voltage across a specific OLED device is below a maximum threshold voltage, then digital correction may be implemented through the color correction algorithms. However, if the voltage is greater than the maximum threshold voltage, an adjustment must be made to the overall supply voltage. Digital voltage correction is preferred to supply voltage correction because it allows finer light output control for specific OLED devices within OLED circuitry 310. Adjustments to the overall supply voltage level for a given module 130 causes CCD controller 330 to increase power dissipation for each OLED device within OLED circuitry 310, even those that did not require additional voltage. The logic for A/D converter 350 may be included in an ASIC.

EEPROM 360 is any type of electronically erasable storage medium for pervasively storing diagnostic and color correction information. For example, EEPROM 360 may be a Xicor or Atmel model 24C16 or 24C164. EEPROM 360 holds the most recently calculated color correction values used for a preceding video frame, specifically, gamma correction, aging factor, color coordinates, and temperature for each OLED device in a module 130.

The gamma curves (either full gamma curves or parameters that define the curves in order to conserve storage space) for both light and dark values are stored in EEPROM 360 at startup from the system-level controller via the CONTROL$_{(X)}$ bus from tile processing system 220.

Color coordinates for each OLED device within OLED circuitry 310 are also stored in EEPROM 360 in the form of (x y Y), where x and y are the coordinates of the primary emitters and Y is defined as the brightness. Each color in OLED display 100 can be described by its tristimulus values X, Y, Z in the CIE color space. The Y value represents contributions to the brightness perception of the human eye and it is called the brightness or luminance. A color can also be described by Y and the color functions x, y, z; where $x = \dfrac{X}{X+Y+Z}$ , $y = \dfrac{Y}{X+Y+Z}$ , $z = \dfrac{Z}{X+Y+Z}$ , and $x+y+z=1$. Given the design white point and brightness, for example, 6500K white at 500 Nit, (e.g., D65), and the color coordinates of the primary emitters ($x_i, y_i$), the individually required brightness $Y_i$ can be calculated from the following equation:

$$\begin{pmatrix} X_{D65} \\ Y_{D65} \\ Z_{D65} \end{pmatrix} = Y_{D65} \begin{pmatrix} \dfrac{x_{D65}}{y_{D65}} \\ 1 \\ \dfrac{1 - x_{D65} - y_{D65}}{y_{D65}} \end{pmatrix} = \sum_{i=R,G,B} Y_i \begin{pmatrix} \dfrac{x_i}{y_i} \\ 1 \\ \dfrac{1 - x_i - y_i}{y_i} \end{pmatrix}$$

The aging factor is a value based on the total on time and total amount of current through each OLED device within OLED circuitry 310.

Other information may be stored in EEPROM 360 at any time without deviating from the spirit and scope of the present invention. Communication to EEPROM 360 is accomplished via EEPROM I/O bus. An advantage to storing color correction and additional information specific to OLED devices within OLED circuitry 310 locally on EEPROM 360 is that when new modules 130 are added to tiles 140, or when modules 130 are rearranged within tiles 140, valuable color correction, aging factors, and other details regarding the operation of module 130 are also transported. Therefore, the new tile processing system 220 is able to read the existing color correction information specific to that module 130 from its local EEPROM 360 at any time and to make adjustments to the overall tile 140 controls.

Module interface 370 serves as an interface between tile processing system 220 and all elements within OLED module processing systems 210. Module interface 370 collects the current temperature data from temperature sensor 380 and the current color coordinate information (tri-stimulus values in the form of x,y,Y), aging measurements, and runtime values from EEPROM 360 for each OLED device within OLED circuitry 310. In addition, module interface 370 collects the digital voltage values during the on time of each OLED device within OLED circuitry 310 from A/D converter 350. Module interface 370 also receives control data, i.e., $CONTROL_{(X)}$ bus, from tile processing system 220 that dictates to pre-processor 340 how to perform color correction (from a tile-level point of view) for the current video frame. For example, OLED display 100 may be outdoors and the ambient light may be fading, thus less light output is required from the overall OLED display 100. This information is sent to each tile 140 as a value 'A', where $0 \le A \le 1$ and 'A' corresponds the relative level of ambient light (0 being no ambient light and 1 being the most amount of ambient light). Each tile processing system 220 further relays the information 'A' to each of its OLED module processing systems 210.

Temperature sensor 380 is a conventional sensing device that takes temperature readings within module 130 to determine the temperature of the OLED devices within module 130. Accurate temperature readings are critical in order to correctly adjust for color correction. Based on the temperature of each OLED device within OLED circuitry 310, the current may be adjusted to compensate for the variation in light output caused by temperature. For example, an OLED device that produces less light at higher temperatures needs higher amounts of current to produce the same light output equivalent at a lower temperature. By contrast, other OLED devices produce more light at higher temperatures and, therefore, the current must be limited through those devices to produce an equivalent light output. Temperature information from temperature sensor 380 is sent to module interface 370 for processing via the TEMPERATURE DATA bus. An example temperature sensor 380 is an Analog Devices AD7416 device.

Figure 4 illustrates a schematic diagram of OLED circuitry 310, which is representative of a portion of a typical common-anode, passive-matrix, large-screen OLED array. OLED circuitry 310 includes an OLED array 410 formed of a plurality of OLEDs 420 (each having an anode and cathode, as is well known) arranged in a matrix of rows and columns. For example, OLED array 410 is formed of OLEDs 420a, 420b, 420c, 420d, 420e, 420f, 420g, 420h, and 420j arranged in a 3x3 array, where the anodes of OLEDs 420a, 420b, and 420c are electrically connected to a ROW LINE 1, the anodes of OLEDs 420d, 420e, and 420f are electrically connected to a ROW LINE 2, and the anodes of OLEDs 420g, 420h, and 420j are electrically connected to a ROW LINE 3. Furthermore, the cathodes of OLEDs 420a, 420d, and 420g are electrically connected to a COLUMN LINE A, the cathodes of OLEDs 420b, 420e, and 420h are electrically connected to a COLUMN LINE B, and the cathodes of OLEDs 420c, 420f, and 420j are electrically connected to a COLUMN LINE C.

A pixel, by definition, is a single point or unit of programmable color in a graphic image. However, a pixel may include an arrangement of sub-pixels, for example, red, green, and blue sub-pixels. Each OLED 420 represents a sub-pixel (typically red, green, or blue; however, any color variants are acceptable) and emits light when forward-biased in conjunction with an adequate current supply, as is well known.

COLUMN LINES A, B, and C are driven by separate constant current sources, i.e., a plurality of current sources ($I_{SOURCES}$) 430 or, alternatively, may be connected to $+V_{OLED}$ via a plurality of dual-position switches 440. More specifically, COLUMN LINE A is electrically connected to either $I_{SOURCE}$ 430a or $+V_{OLED}$ via switch 440a, COLUMN LINE B is electrically connected to either $I_{SOURCE}$ 430b or $+V_{OLED}$ via switch 440b, and COLUMN LINE C is electrically connected to either $I_{SOURCE}$ 430c or $+V_{OLED}$ via switch 440c. $I_{SOURCES}$ 430 are conventional current sources capable of supplying a constant current typically in the range of 5 to 50 mA. Examples of constant current devices include a Toshiba TB62705 (8-bit constant current LED driver with shift register and latch functions) and a Silicon Touch ST2226A (PWM-controlled constant current driver for LED displays). Switches 440 are formed of conventional active switch devices, such as MOSFET switches or transistors having suitable voltage and current ratings. The state of switches 440 is controlled by PWM CONTROL bus from CCD controller 330 of figure 3.

Either a positive voltage ($+V_{OLED}$), typically ranging between 3 volts (i.e., threshold voltage 1.5V to 2V + voltage over current source, usually 0.7 V) and 15-20 volts, or ground may be electrically connected to each respective ROW LINE via a plurality of dual-position bank switches 450. More specifically, ROW LINE 1 is electrically connected to either $+V_{OLED}$ or ground via bank switch 450a, ROW LINE 2 is electrically connected to either $+V_{OLED}$ or ground via bank switch 450b, and ROW LINE 3 is electrically connected to either $+V_{OLED}$ or ground via bank switch 450c. Bank switches 450 are formed of conventional active switch devices, such as MOSFET switches or transistors having suitable voltage and current ratings. The state of bank switches 450 is controlled by the $V_{OLED}$ CONTROL bus from bank switch controller 320 of figure 3.

Lastly, COLUMN LINES A, B, and C may be electrically connected to ground via a plurality of pre-charge (P-C) switches 460. More specifically, COLUMN LINE A may be electrically connected to ground via P-C switch 460a, COLUMN LINE B may be electrically connected to ground via P-C switch 460b, and COLUMN LINE C may be electrically connected to ground via P-C switch 460c. P-C switches 460 are formed of conventional active switch devices, such as MOSFET switches or transistors having suitable voltage and current ratings. The state of P-C switches 460 is controlled by the $V_{PRE-C}$ CONTROL bus from CCD controller 330 of figure 3. The logic for P-C switches 460 may be located in an ASIC.

The matrix of OLEDs 420 within OLED circuitry 310 is arranged in the common anode configuration. In this way, the voltage across the current source is referenced to the ground and is therefore independent of the supply voltage. This is a more stable way to drive the current.

With reference to figures 3 and 4, the general operation of OLED module processing system 210 is as follows. CCD controller 330 decodes the CCD CONTROL bus from pre-processor 340 to produce PWM signals, i.e., PWM CONTROL bus, which subsequently drive $I_{SOURCES}$ 430. The width of the active portion of each PWM CONTROL determines the length of time a particular OLED 420 is lit. The amount of current that each $I_{SOURCE}$ 430 drives is determined by pre-processor 340 based on color correction algorithms and the $RGB_{(X)}$ signal. Subsequently, CCD controller 330 transmits the current control information to each corresponding $I_{SOURCE}$ 430. Furthermore, bank switch controller 320 receives bank control data i.e., BANK CONTROL bus, from pre-processor 340 and transmits this control data via the $V_{OLED}$ CONTROL bus to the corresponding anodes of OLEDs 420. The BANK CONTROL bus controls bank switches 450, which subsequently apply either $+V_{OLED}$ or ground to a particular OLED 420. The combination of applying a predetermined voltage to the anode of an OLED 420 while simultaneously applying a current to its cathode causes light emission from the corresponding OLED 420 for a specific length of time at a given intensity. In this manner, OLED module processing system 210 is able to drive OLEDs 420 with maximum degree of control.

To activate (light up) any given OLED 420, its associated ROW LINE is connected to $+V_{OLED}$ via its bank switch 450, and its associated COLUMN LINE is connected to its $I_{SOURCE}$ 430 via its switch 440. In order to prevent reverse current from flowing through the neighboring OLEDs 420, causing an alternate current path to ground and allowing low levels of undesired light emission, all remaining ROW LINES are connected to ground via their respective bank switches 450 and all remaining COLUMN LINES are connected to $+V_{OLED}$ via their respective switches 440. This reverse current is due to the low inverse resistance characteristics of a typical OLED 420, as is well known. Furthermore, to rapidly charge the parasitic capacitance associated with the structure of OLEDs 420, a pre-charge cycle occurs just prior to the on-time cycle by briefly connecting the cathode of the selected OLED 420 to ground via its P-C switch 460 connecting to its associated COLUMN LINE. In this way, the duty cycle is maximized by not having to wait for the parasitic capacitance of the selected OLED 420 to charge.

With reference to figures 3 and 4, the operation of a specific OLED 420 is as follows. A full cycle of operation includes a brief pre-charge cycle followed by an on-time cycle. For example, in order to light up OLED 420b, simultaneously, $+V_{OLED}$ is applied to ROW LINE 1 by appropriately selecting the state of bank switch 450a, $I_{SOURCE}$ 430b is connected to COLUMN LINE B by appropriately selecting the state of switch 440b, and COLUMN LINE B is briefly connected to ground by briefly closing P-C switch 460b, thereby rapidly charging OLED 420b. Once the pre-charge cycle is completed, P-C switch 460b is opened, leaving only the constant current of $I_{SOURCE}$ 430b connected to COLUMN LINE B. At the same time, ROW LINES 2 and 3 are connected to ground by appropriately selecting the state of bank switches 450b and 450c, respectively, and COLUMN LINES A and C are connected to $+V_{OLED}$ by appropriately selecting the state of switches 440a and 440c, respectively. In this way, OLED 420b is forward biased and current flows through OLED 420b. Once the device threshold voltage of typically 1.5-2 volts is achieved at its cathode, OLED 420b emits light. OLED 420b remains lit up as long as bank switch 450a is selecting $+V_{OLED}$ and as long as switch 440b is selecting $I_{SOURCE}$ 430b. To deactivate OLED 420b, the state of switch 440b is toggled to its opposite state and the forward biasing of OLED 420b is removed. Along a given ROW LINE, any one or more OLED 420 may be activated at any given time. By contrast, along a given COLUMN LINE, only one OLED 420 may be activated at any given time. In the above-described operation, the states of all switches 440 are dynamically controlled by PWM CONTROL bus, the states of all bank switches 450 are dynamically controlled by $V_{OLED}$ CONTROL, and the states of all P-C switches 460 are dynamically controlled by $V_{PRE-C}$ CONTROL bus.

Additionally, voltage levels are measured across each $I_{SOURCE}$ 430 while applying voltage to the anode of each OLED 420 and fed back to A/D converter 350 via the ANALOG VOLTAGE bus. A/D converter 350 subsequently transmits DIGITAL VOLTAGE corresponding to each specific OLED 420 to pre-processor 340 for further processing.

Tables 1 and 2 below illustrate a truth table of the state of each active switch within OLED circuitry 310 for operating each OLED 420 during the pre-charge cycle and the on-time cycle, respectively.

Table 1: Truth table of switch states for pre-charging each OLED 420 of OLED circuitry 310 during the pre-charge cycle

| To pre-charge OLED | Switches | | | | | | | | |
|---|---|---|---|---|---|---|---|---|---|
| | 440a | 440b | 440c | 450a | 450b | 450c | 460a | 460b | 460c |
| 420a | $I_{SOURCE}$ | $V_{OLED}$ | $V_{OLED}$ | $V_{OLED}$ | Ground | Ground | $V_{PRE-C}$ | Open | open |

(continued)

| To pre-charge OLED | Switches | | | | | | | | |
|---|---|---|---|---|---|---|---|---|---|
| | 440a | 440b | 440c | 450a | 450b | 450c | 460a | 460b | 460c |
| 420b | $V_{OLED}$ | $I_{SOURCE}$ | $V_{OLED}$ | $V_{OLED}$ | Ground | Ground | open | $V_{PRE-C}$ | open |
| 420c | $V_{OLED}$ | $V_{OLED}$ | $I_{SOURCE}$ | $V_{OLED}$ | Ground | Ground | open | Open | $V_{PRE-C}$ |
| 420d | $I_{SOURCE}$ | $V_{OLED}$ | $V_{OLED}$ | Ground | $V_{OLED}$ | Ground | $V_{PRE-C}$ | Open | open |
| 420e | $V_{OLED}$ | $I_{SOURCE}$ | $V_{OLED}$ | Ground | $V_{OLED}$ | Ground | open | $V_{PRE-C}$ | open |
| 420f | $V_{OLED}$ | $V_{OLED}$ | $I_{SOURCE}$ | Ground | $V_{OLED}$ | Ground | open | Open | $V_{PRE-C}$ |
| 420g | $I_{SOURCE}$ | $V_{OLED}$ | $V_{OLED}$ | Ground | Ground | $V_{OLED}$ | $V_{PRE-C}$ | Open | open |
| 420h | $V_{OLED}$ | $I_{SOURCE}$ | $V_{OLED}$ | Ground | Ground | $V_{OLED}$ | open | $V_{PRE-C}$ | open |
| 420j | $V_{OLED}$ | $V_{OLED}$ | $I_{SOURE}$ | Ground | Ground | $V_{OLED}$ | open | Open | $V_{PRE-C}$ |

Table 2: Truth table of switch states for activating each OLED 420 of OLED circuitry 310 during the on-time cycle

| To activate OLED | Switches | | | | | | | | |
|---|---|---|---|---|---|---|---|---|---|
| | 440a | 440b | 440c | 450a | 450b | 450c | 460a | 460b | 460c |
| 420a | $I_{SOURCE}$ | $V_{OLED}$ | $V_{OLED}$ | $V_{OLED}$ | ground | ground | open | Open | open |
| 420b | $V_{OLED}$ | $I_{SOURCE}$ | $V_{OLED}$ | $V_{OLED}$ | ground | ground | open | Open | open |
| 420c | $V_{OLED}$ | $V_{OLED}$ | $I_{SOURCE}$ | $V_{OLED}$ | ground | ground | open | Open | open |
| 420d | $I_{SOURCE}$ | $V_{OLED}$ | $V_{OLED}$ | ground | $V_{OLED}$ | ground | open | open | open |
| 420e | $V_{OLED}$ | $I_{SOURCE}$ | $V_{OLED}$ | ground | $V_{OLED}$ | ground | open | open | open |
| 420f | $V_{OLED}$ | $V_{OLED}$ | $I_{SOURCE}$ | ground | $V_{OLED}$ | ground | open | open | open |
| 420g | $I_{SOURCE}$ | $V_{OLED}$ | $V_{OLED}$ | ground | ground | $V_{OLED}$ | open | open | open |
| 420h | $V_{OLED}$ | $I_{SOURCE}$ | $V_{OLED}$ | ground | ground | $V_{OLED}$ | open | open | open |
| 420j | $V_{OLED}$ | $V_{OLED}$ | $I_{SOURCE}$ | ground | ground | $V_{OLED}$ | open | open | open |

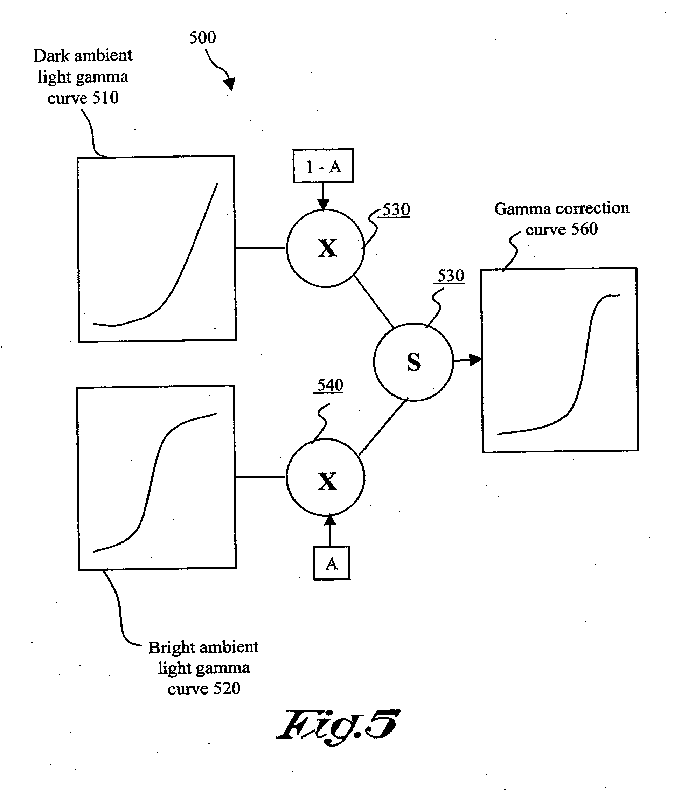

Figure 5 shows a diagram of the gamma correction function 500 in accordance with the invention. Gamma correction function 500 includes a dark ambient light gamma curve 510, a bright ambient light gamma curve 520, a multiplier function 530, a multiplier function 540, a summation function 550, and a gamma correction curve 560. Pre-processor 340 performs gamma correction using black level control algorithms with at least two gamma curves, i.e., dark ambient light gamma curve 510 and bright ambient light gamma curve 520, which may be stored locally or in EEPROM 360 or may be calculated by pre-processor 340. Dark ambient light gamma curve 510 corresponds to low ambient light conditions for OLED display 100 and bright ambient light gamma curve 520 corresponds to sunlight ambient light conditions. Module interface 370 forwards the value 'A' to pre-processor 340 according to the level of ambient light detected by OLED display 100. The black level controller algorithm multiplies 'A' by bright ambient light gamma curve 520 at multiplier function 540, multiplies '1 - A' by dark ambient light gamma curve 510 at multiplier function 530, and adds the two outputs at summation function 550. Thus, the result is new gamma correction curve 560 proportional to the two gamma tables stored in EEPROM 360. New gamma correction curve 560 is corrected based on the ambient light of OLED display 100. The resultant gamma curve is stored in pre-processor 340 and is used for calculating the color corrections for each OLED 420 for the current frame. If pre-processor 340 has sufficient processing capabilities, dark ambient light gamma curve 510 and bright ambient light gamma curve 520 may be calculated within pre-processor 340. However, if pre-processor 340 does not possess sufficient processing capabilities, it reads the existing gamma curves stored in EEPROM 360 instead.

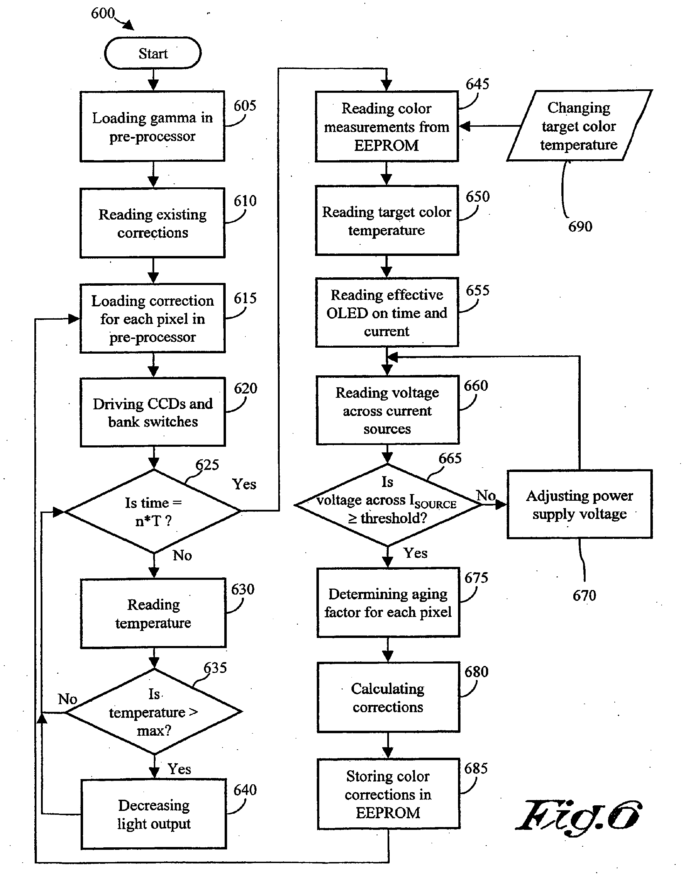

Figure 6 is a flow diagram of a method 600 of operating module 130 in accordance with the invention with reference to figures 1 through 5 incorporated therein. Method 600 includes the following steps:

Step 605: Loading gamma in pre-processor

In this step, OLED module processing system 210 of module 130 is initialized and pre-processor 340 reads the existing gamma curve points from EEPROM 360 or calculates the gamma curves based on control data, i.e., $CONTROL_{(X)}$ bus, from tile processing system 220. The gamma curve points may have been stored previously in the local memory of pre-processor 340 during the last initialization cycle, or the points may have been loaded by an external processing unit. The gamma value is a curve defined by ten points (one starting slope point, one ending slope point and four x,y coordinate points in between) and is used to convert the 8-bit digitized $RGB_{(X)}$ data into a 10- to 14-bit value used by CCD controller 330 to control the current driven by $I_{SOURCES}$ 430 of OLED circuitry 310. The resulting gamma curve yields the formula for calculating the corresponding 10- to 14-bit output values from the 8-bit input values for each sub-pixel, thereby adding more resolution and fine-tuning capability to module 130. Method 600 proceeds to step 610.

Step 610: Reading existing corrections

In this step, pre-processor 340 reads other existing color correction data, including color coordinates and brightness values (x,y,Y), target color temperature (e.g., 6500K), aging factors (i.e., the on time and total current flow for each OLED 420), and the temperature of module 130, from the values stored in EEPROM 360. Method 600 proceeds to step 615.

Step 615: Loading correction for each pixel in pre-processor

In this step, pre-processor 340 loads the system-level color correction information for each OLED 420 of OLED circuitry 310. System-level color correction values include adjusting for ambient light conditions and changes to color temperature (e.g., adjusting to display to show outdoor daylight whites verses indoor daylight whites). Method 600 proceeds to step 620.

Step 620: Driving CCDs and bank switches

In this step, for a given frame, pre-processor 340 commands bank switch controller 320 and CCD controller 330 to activate each OLED 420 of OLED circuitry 310 accordingly. Using the color correction information from pre-processor 340, CCD controller 330 is able to calculate the amount of time to drive each $I_{SOURCE}$ 430. Additionally, CCD controller 330 interprets CCD CONTROL from pre-processor 340 and generates PWM CONTROL to OLED circuitry 310 for setting the drive current of $I_{SOURCES}$ 430. The length of time the current is driven for a particular OLED 420 is controlled by PWM CONTROL. While a given PWM CONTROL is active and the anode of a particular OLED 420 is connected to $V_{OLED}$ via bank switch 450, the particular OLED 420 emits light at a given intensity according to the voltage and current requirements defined and stored in pre-processor 340. Method 600 proceeds to step 625.

Step 625: Is time = n * T?

In this decision step, pre-processor 340 compares a pre-stored time period value T multiplied by a count n (n = 1, 2, 3, ...) to determine the amount of time that has elapsed since the last color measurements were taken. If the time elapsed equals the required time n * T, method 600 proceeds to step 645; if not, method 600 proceeds to step 630.

Step 630: Reading temperature

In this step, module interface 370 receives the temperature value, i.e., via TEMPERATURE DATA bus, as detected by temperature sensor 380 and forwards the current temperature value to pre-processor 340 via DATA I/O bus. Method 600 proceeds to step 635.

Step 635: Is temperature > max?

In this decision step, pre-processor 340 compares the current temperature value with that of a predetermined maximum temperature value stored locally. If the temperature exceeds the maximum temperature value, method 600 proceeds to step 640; if not, method 600 returns to step 625.

Step 640: Decreasing light output

In this step, pre-processor 340 decreases the values for the digital contrast to lower the light output levels in order to bring the temperature into compliance. This is accomplished by decreasing the amount of current provided by $I_{SOURCES}$ 430 to OLEDs 420 in small decremented amounts. Method 600 returns to step 625.

Step 645: Reading color measurements from EEPROM

In this step, pre-processor 340 reads the color measurements (x,y,Y) from EEPROM 360. The external processing unit may have adjusted these values for a system-level adjustment or pre-processor 340 may have calculated and stored new values during the last time interval. Method 600 proceeds to step 650.

Step 650: Reading target color temperature

In this step, pre-processor 340 reads the target color temperature value from EEPROM 360. The target color temperature value is controlled by the external processing unit and stored in EEPROM 360 of each OLED module processing system 210. The target color temperature value may change at any time. Method 600 proceeds to step 655.

Step 655: Reading effective OLED on time and current

In this step, pre-processor 340 reads the effective OLED on time values for each OLED 420. The values may be stored in local RAM, or pre-processor 340 may calculate the values directly from data stored in its registers. The values provide information regarding the duration of the on time for each individual OLED 420 during that time interval. Pre-processor 340 combines the new on time and current information additively with its existing information for the on time and current flow through each OLED 420. Method 600 proceeds to step 660.

Step 660: Reading voltage across current sources

In this step, A/D converter 350 reads the analog voltage value across each $I_{SOURCE}$ 430 while bank switch controller 320 applies a voltage to the anode of each OLED 420. A/D converter 350 further converts the analog value to a digital equivalent. A/D converter 350 sends the digitized voltage information corresponding to each $I_{SOURCE}$ 430 to pre-processor 340 via the DIGITAL VOLTAGE bus. Method 600 proceeds to step 665.

Step 665: Is voltage across $I_{SOURCE} \geq$ threshold?

In this step, pre-processor 340 compares the digital value of the voltage across the corresponding $I_{SOURCE}$ 430 provided by A/D converter 350 of the worst OLED 420 (i.e., with the lowest voltage value) to a pre-stored minimum threshold voltage value. If the voltage value across the corresponding $I_{SOURCE}$ 430 for that particular OLED 420 exceeds the pre-stored minimum threshold voltage, method 600 proceeds to step 675; if not, method 600 proceeds to step 670.

Step 670: Adjusting power supply voltage

In this step, pre-processor 340 increases the power supply voltage using an analog correction that incrementally increases the voltage supply to all OLEDs 420 within OLED circuitry 310 of module 130. Further digital adjustments are made on a per-OLED 420 basis in step 680. Method 600 returns to step 660.

Step 675: Determining aging factor for each pixel

In this step, pre-processor 340 calculates the new aging factor for each OLED 420 using the new on time values, current amounts, and voltages. Since the age of OLED 420 impacts its performance, it is important to determine OLED 420's age in order to predict its current light output capabilities. For example, the older an OLED 420 is, the more current is required to produce the same amount of light output as when it was newer. Method 600 proceeds to step 680.

Step 680: Calculating corrections

In this step, pre-processor 340 uses the aging factor of each OLED 420 calculated in step 675, as well as the tristimulus values, the target color temperature, and the temperature of module 130, to determine the color correction for each OLED 420. The color correction for each OLED 420 is a value indicating additional or subtractive current to be combined with the digitized $RGB_{(X)}$ data to produce the optimized intensity of each OLED 420. Digital voltage supply correction for each individual OLED 420 is also performed in this step. Method 600 proceeds to step 685.

Step 685: Storing color corrections in EEPROM

In this step, pre-processor 340 stores the color correction values calculated in step 680 in EEPROM 360. Therefore, the color correction values are available for the next frame to be displayed; if module 130 is removed and inserted in a new location within tile 140, the color correction values are also transported with module 130. Finally, if OLED display 100 powers down, the color correction values are stored and available for use the next time OLED display 100 powers on. Method 600 returns to step 615.

Interrupt 690: Changing target color temperature

In this interrupt step, an external processing unit changes the color temperature value and writes the new value to each EEPROM 360 of each OLED module processing system 210. Method 600 proceeds to step 645.

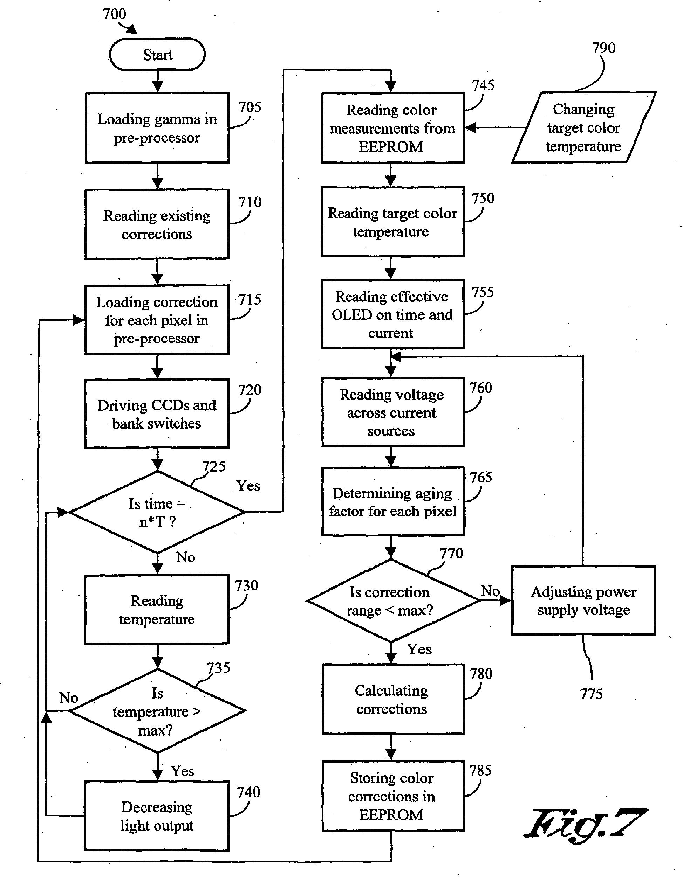

Figure 7 is a flow diagram of an alternative method 700 of operating module 130 in accordance with the invention with reference to figures 1 through 5 incorporated therein. Method 700 includes the following steps.

Step 705: Loading gamma in pre-processor

In this step, OLED module processing system 210 of module 130 is initialized and pre-processor 340 reads the existing gamma curve points from EEPROM 360 or calculates the gamma curves based on control data, i.e., $CONTROL_{(X)}$ bus, from tile processing system 220. The gamma curve points may have been stored previously in the local memory of pre-processor 340 during the last initialization cycle, or the points may have been loaded by an external processing unit. The gamma value is a curve defined by ten points (one starting slope point, one ending slope point and four x,y coordinate points in between) and is used to convert the 8-bit digitized $RGB_{(X)}$ data into a 10- to 14-bit value used by CCD controller 330 to control the current driven by $I_{SOURCES}$ 430 of OLED circuitry 310. The resulting gamma curve yields the formula for calculating the corresponding 10- to 14-bit output values from the 8-bit input values for each sub-pixel, thereby adding more resolution and fine-tuning capability to module 130. Method 700 proceeds to step 710.

Step 710: Reading existing corrections

In this step, pre-processor 340 reads other existing color correction data, including color coordinates and brightness values (x,y,Y), target color temperature (e.g., 6500K), aging factors (i.e., the on time and total current flow for each OLED 420), and the temperature of module 130, from the values stored in EEPROM 360. Method 700 proceeds to step 715.

Step 715: Loading correction for each pixel in pre-processor
In this step, pre-processor 340 loads the system-level color correction information.for each OLED 420 of OLED circuitry 310. System-level color correction values include adjusting for ambient light conditions and changes to color temperature (e.g., adjusting to display to show outdoor daylight whites verses indoor daylight whites). Method 700 proceeds to step 720.

Step 720: Driving CCDs and bank switches
In this step, for a given frame, pre-processor 340 commands bank switch controller 320 and CCD controller 330 to activate each OLED 420 of OLED circuitry 310 accordingly. Using the color correction information from pre-processor 340, CCD controller 330 is able to calculate the amount of time to drive each $I_{SOURCE}$ 430. Additionally, CCD controller 330 interprets CCD CONTROL from pre-processor 340 and generates PWM CONTROL to OLED circuitry 310 for setting the drive current of $I_{SOURCES}$ 430. The length of time the current is driven for a particular OLED 420 is controlled by PWM CONTROL. While a given PWM CONTROL is active and the anode of a particular OLED 420 is connected to $V_{OLED}$ via bank switch 450, the particular OLED 420 emits light at a given intensity according to the voltage and current requirements defined and stored in pre-processor 340. Method 700 proceeds to step 725.

Step 725: Is time = n * T?
In this decision step, pre-processor 340 compares a pre-stored time period value T multiplied by a count n (n = 1, 2, 3, ...) to determine the amount of time that has elapsed since the last color measurements were taken. If the time elapsed equals the required time n * T, method 700 proceeds to step 745; if not, method 700 proceeds to step 730.

Step 730: Reading temperature
In this step, module interface 370 receives the temperature value, i.e., via TEMPERATURE DATA bus, as detected by temperature sensor 380 and forwards the current temperature value to pre-processor 340 via DATA I/O bus. Method 700 proceeds to step 735.

Step 735: Is temperature > max?
In this decision step, pre-processor 340 compares the current temperature value with that of a predetermined maximum temperature value stored locally. If the temperature exceeds the maximum temperature value, method 700 proceeds to step 740; if not, method 700 returns to step 725.

Step 740: Decreasing light output
In this step, pre-processor 340 decreases the values for the digital contrast to lower the light output levels in order to bring the temperature into compliance. This is accomplished by decreasing the amount of current provided by $I_{SOURCES}$ 430 to OLEDs 420 in small decremented amounts. Method 700 returns to step 725.

Step 745: Reading color measurements from EEPROM
In this step, pre-processor 340 reads the color measurements (x,y,Y) from EEPROM 360. The external processing unit may have adjusted these values for a system-level adjustment or pre-processor 340 may have calculated and stored new values during the last time interval. Method 700 proceeds to step 750.

Step 750: Reading target color temperature
In this step, pre-processor 340 reads the target color temperature value from EEPROM 360. The target color temperature value is controlled by the external processing unit and stored in EEPROM 360 of each OLED module processing system 210. The target color temperature value may change at any time. Method 700 proceeds to step 755.

Step 755: Reading effective OLED on time and current
In this step, pre-processor 340 reads the effective OLED on time values for each OLED 420. The values may be stored in local RAM, or pre-processor 340 may calculate the values directly from data stored in its registers. The values provide information regarding the duration of the on time for each individual OLED 420 during that time interval. Pre-processor 340 combines the new on time and current information additively with its existing information for the on-time and current flow through each OLED 420. Method 700 proceeds to step 760.

Step 760: Reading voltage across current sources
In this step, A/D converter 350 reads the analog voltage value across each $I_{SOURCE}$ 430 while bank switch controller 320 applies a voltage to the anode of each OLED 420. A/D converter 350 further converts the analog value to a digital equivalent. A/D converter 350 sends the digitized voltage information corresponding to each $I_{SOURCE}$ 430 to pre-processor 340 via the DIGITAL VOLTAGE bus. Method 700 proceeds to step 765.

Step 765: Determining aging factor for each pixel
In this step, pre-processor 340 calculates the new aging factor for each OLED 420 using the new on time values, current amounts, and voltages. Since the age of OLED 420 impacts its performance, it is important to determine OLED 420's age in order to predict its current light output capabilities. For example, the older an OLED 420 is, the more current is required to produce the same amount of light output as when it was newer. Method 700 proceeds to step 770.

Step 770: Is correction range < max?
In this decision step, pre-processor 340 has already determined the aging factor for each OLED 420 in step 765. Since the aging factor is a digital value for each OLED 420, a digital correction adjustment may be made to each individual OLED 420 if the correction range is less than a predetermined maximum. If the correction range is less than the maximum, method 700 proceeds to step 780. If the correction range is greater than the predetermined maximum, a digital correction is not possible, and method 700 proceeds to step 775.

Step 775: Adjusting power supply voltage
In this step, pre-processor 340 increases the power supply voltage using an analog correction that incrementally increases the voltage supply to all OLEDs 420 within OLED circuitry 310 of module 130. Further digital adjustments are made on a per-OLED 420 basis in step 780. Method 700 returns to step 760.

Step 780: Calculating corrections
In this step, pre-processor 340 uses the aging factor of each OLED 420 calculated in step 765, as well as the tristimulus values, the target color temperature, and the temperature of module 130, to determine the color correction for each OLED 420. The color correction for each OLED 420 is a value indicating additional or subtractive current to be combined with the digitized $RGB_{(X)}$ data to produce the optimized intensity of each OLED 420. Digital voltage supply correction for each individual OLED 420 is also performed in this step. Method 700 proceeds to step 785.

Step 785: Storing color corrections in EEPROM
In this step, pre-processor 340 stores the color correction values calculated in step 780 in EEPROM 360. Therefore, the color correction values are available for the next frame to be displayed; if module 130 is removed and inserted in a new location within tile 140, the color correction values are also transported with module 130. Finally, if OLED display 100 powers down, the color correction values are stored and available for use the next time OLED display 100 powers on. Method 700 returns to step 715.

Interrupt 790: Changing target color temperature
In this interrupt step, an external processing unit changes the color temperature value and writes the new value to each EEPROM 360 of each OLED module processing system 210. Method 700 proceeds to step 745.

In reference to methods 600 and 700 above, it is noted that processing occurs in each OLED module processing system 210a through 210j of modules 130a through 130j, respectively, in parallel with processing that occurs in tile processing system 220. As a result, more color correction, resolution enhancement, and light output control is achieved through the additional processing bandwidth available. The hierarchical processing architecture maintains display quality, cohesiveness, and consistency by having the flexibility to control at the module, tile, and overall display levels. For example, displaying an image on a solid white background would be difficult to achieve without all levels of hierarchical control. Since each module 130 has various properties, the white light output from one module 130 may appear yellow when compared next to a neighbouring module 130. Additionally, another module 130 may appear mottled or dithered and not a solid white color. Processing at a higher level allows for corrections to these individual modules 130 such that the appearance of a solid white background is achieved.

The present invention is in no way limited to the forms of embodiment described by way of example and represented in the figures, however, such method for displaying images, as well as such display, can be realized in various forms without leaving the scope of the invention as defined in the attached set of claims.

**Claims**

1. Method for displaying images on a large-screen organic light-emitting diode display, wherein use is made of a light-emitting display (100) comprising an array of light-emitting display tiles (140) that are each formed of an array of smaller light-emitting display modules (130), each display module (130) comprising a number of light-emitting pixels, and wherein each display module (130) includes an intelligent module processing system (210), whereby, in order to display the images, data concerning the image to be displayed, provided by a general processing unit, in other words a system controller, are transmitted to tile processing systems (220) and from each tile processing system (220) towards the respective modules (130), **characterized in that** in use color measurements are taken, and **in that** in each module processing system (210) the amount of time is determined that has been elapsed since the last color measurements were taken, whereby this time is compared with a set value, whereby in case that this time is longer than said set value, a new measurement is carried out, and **in that** the display is an organic light-emitting diode (OLED) display, the display tiles are OLED display tiles, the display modules are OLED display modules, the pixels are OLED pixels, and the module processing system is an OLED processing system.

2. Method according to claim 1, wherein said tile processing systems (220) are serially coupled and in that the data of the general processing unit are transmitted through the subsequent tile processing systems (220).

3. Method according to claim 1 or 2, wherein the general processing unit provides RGB data and control (CNTL) data, whereby data from the RGB data are collected at each individual tile processing system and/or module processing system as a function of control signals generated by means of said control (CNTL) data.

4. Method according to claims 2 and 3, wherein each tile processing system (220) stores the serial RGB data for the particular frame that corresponds to the physical position of the concerned tile (140) within the display (100).

5. Method according to claim 4, wherein each tile processing system (220) parses the received RGB data into specific packets associated with the corresponding OLED module processing systems (210).

6. Method according to any of the preceding claims, wherein said OLED module processing systems (210) make decisions regarding the amount of current to use when driving each OLED pixel in a module (130).

7. Method according to claim 6, wherein said OLED module processing systems (210) use data collection devices and algorithms in order to make said decisions.

8. Method according to any of the preceding claims, wherein in the module processing systems (210) at least the time each individual pixel is "on" is monitored and recorded, whereby the obtained values are used to carry out adjustments when driving the concerned OLED pixels in a module (130).

9. Method according to any of the preceding claims, wherein in the module processing systems (210) at least the amount of current which was used to drive each OLED during the "on" time is monitored and recorded, whereby the obtained values are used to carry out adjustments for subsequently driving the concerned OLED pixels in a module (130).

10. Method according to any of the preceding claims, wherein with regard to the drive of the OLED pixels, one or more adjustments are made at the corresponding tile processing system (220) and/or at the corresponding module processing system (210) itself.

11. Method according to any of the preceding claims, wherein, when driving the respective OLED pixels or OLEDs, adjustments are made taking at least one of the following factors into account: age, temperature, gamma value.

12. Method according to any of the preceding claims, wherein in each module processing system (210), more particularly in a pre-processor (340) of the module processing system (210), use is made of existing color correction data which are red in from values stored in the module processing system (210), as well as of system-level color correction values.

13. Method according to any of the preceding claims, wherein the OLEDs are driven by means of current sources, and in that in each OLED module processing system (210) the voltage across the current source (430) of the worst OLED (420) is compared to a pre-stored minimum threshold voltage value, and if said voltage is lower than the threshold voltage value, an adjustment of the power supply voltage is carried out.

**14.** Method according to claim 13, wherein an aging factor for each pixel is determined, in order to allow further calculation corrections, whereby said aging factor is determined after having carried out said adjustment of the power supply voltage.

**15.** Method according to any of the claims 1 to 13, wherein in each OLED module processing system (210) an aging factor is calculated for each OLED (420) and in that this aging factor is compared to a pre-determined maximum, and if the calculated aging factor is larger than the pre-determined maximum, an adjustment of the power supply voltage for said OLED is carried out.

**16.** Large-screen light-emitting display, more particularly for realizing the method according to any of claims 1 to 15, whereby this display (100) comprises an array of display tiles (140) that are each formed of an array of smaller display modules (130), wherein each display module (130) includes at least one intelligent module processing system (210), and whereby each tile (140) comprises a tile processing system (220), coupled to the respective modules (130) and in communication with each of the module processing systems (220) **characterized in that** the module processing systems (210) comprise electronic means configured so as to carry out the method of any of the claims 1 to 15 and **in that** the display is an organic light-emitting diode (OLED) display, the display tiles are OLED display tiles, the display modules are OLED display modules, the module processing system is an OLED module processing system.

**17.** Large screen light-emitting display according to claim 16, it is configured such that the size and dimension can be changed by adding or removing tiles.

**18.** Large screen light-emitting display, according to claim 16, which is configured such that the modules are replaceable.

**Patentansprüche**

**1.** Verfahren zur Anzeige von Bildern auf einer organischen Leuchtdioden-Großbildanzeige, wobei eine Leuchtanzeige (100) verwendet wird, die eine Anordnung von Leucht-Anzeigekacheln (140) umfasst, die jede von einer Anordnung kleinerer Leucht-Anzeigemodule (130) gebildet werden, wobei jedes Anzeigemodul (130) eine Anzahl von Leuchtpixeln umfasst, und wobei jedes Anzeigemodul (130) ein intelligentes Modulverarbeitungssystem (210) umfasst, wobei zur Anzeige der Bilder Daten, die das anzuzeigende Bild betreffen, die von einer allgemeinen Verarbeitungseinheit bereitgestellt werden, mit anderen Worten, einer Systemsteuereinrichtung, zu Kachelverarbeitungssystemen (220) und von jedem Kachelverarbeitungssystem (220) zu den jeweiligen Modulen (130) übertragen werden, **dadurch gekennzeichnet, dass** im Gebrauch Farbmessungen vorgenommen werden und dass in jedem Modulverarbeitungssystem (210) die Zeit ermittelt wird, die verstrichen ist, seit die letzten Farbmessungen vorgenommen wurden, wobei diese Zeit mit einem eingestellten Wert verglichen wird, wobei, falls diese Zeit länger als der eingestellte Wert ist, eine neue Messung ausgeführt wird, und dass die Anzeige eine organische Leuchtdioden(OLED)-Anzeige ist, die Anzeigekacheln OLED-Anzeigekacheln sind, die Anzeigemodule OLED-Anzeigemodule sind, die Pixel OLED-Pixel sind und das Modulverarbeitungssystem ein OLED-Verarbeitungssystem ist.

**2.** Verfahren nach Anspruch 1, wobei die Kachelverarbeitungssysteme (220) in Reihe geschaltet sind und wobei die Daten der allgemeinen Verarbeitungseinheit durch die nachfolgenden Kachelverarbeitungssysteme (220) übertragen werden.

**3.** Verfahren nach Anspruch 1 oder 2, wobei die allgemeine Verarbeitungseinheit RGB-Daten und Steuer(CNTL)-Daten bereitstellt, wobei Daten von den RGB-Daten an jedem einzelnen Kachelverarbeitungssystem und/oder Modulverarbeitungssystem in Funktion von mittels der Steuer(CNTL)-Daten erzeugten Steuersignalen gesammelt werden.

**4.** Verfahren nach Ansprüchen 2 und 3, wobei jedes Kachelverarbeitungssystem (220) die seriellen RGB-Daten für das jeweilige Einzelbild speichert, das der physikalischen Position der betreffenden Kachel (140) in der Anzeige (100) entspricht.

**5.** Verfahren nach Anspruch 4, wobei jedes Kachelverarbeitungssystem (220) die empfangenen RGB-Daten in spezifische Pakete parst, die den entsprechenden OLED-Modulverarbeitungssystemen (210) zugeordnet sind.

**6.** Verfahren nach einem der vorgenannten Ansprüche, wobei die OLED-Modulverarbeitungssysteme (210) Entscheidungen in Hinblick auf den Strombetrag treffen, der beim Treiben jedes OLED-Pixels in einem Modul (130) zu verwenden ist.

7. Verfahren nach Anspruch 6, wobei die OLED-Modulverarbeitungssysteme (210) Datensammelvorrichtungen und -algorithmen verwenden, um diese Entscheidungen zu treffen.

8. Verfahren nach einem der vorgenannten Ansprüche, wobei in den Modulverarbeitungssystemen (210) mindestens die Zeit, während der jedes einzelne Pixel "an" ist, überwacht und aufgezeichnet wird, wobei die erhaltenen Werte verwendet werden, um beim Treiben der betreffenden OLED-Pixel in einem Modul (130) Anpassungen auszuführen.

9. Verfahren nach einem der vorgenannten Ansprüche, wobei in den Modulverarbeitungssystemen (210) mindestens der Strombetrag, der zum Treiben jeder OLED während der "An"-Zeit verwendet wurde, überwacht und aufgezeichnet wird, wobei die erhaltenen Werte verwendet werden, um Anpassungen zum anschließenden Treiben der betreffenden OLED-Pixel in einem Modul (130) durchzuführen.

10. Verfahren nach einem der vorgenannten Ansprüche, wobei unter Bezug auf das Treiben der OLED-Pixel ein oder mehrere Anpassungen an dem entsprechenden Kachelverarbeitungssystem (220) und/oder an dem entsprechenden Modulverarbeitungssystem (210) selbst vorgenommen werden.

11. Verfahren nach einem der vorgenannten Ansprüche, wobei beim Treiben der jeweiligen OLED-Pixel oder OLEDs Anpassungen durchgeführt werden, unter Berücksichtigung mindestens eines der folgenden Faktoren: Alter, Temperatur, Gammawert.

12. Verfahren nach einem der vorgenannten Ansprüche, wobei in jedem Modulverarbeitungssystem (210), spezieller in einem Vorprozessor (340) des Modulverarbeitungssystems (210), von bestehenden Farbkorrekturdaten, die von in dem Modulverarbeitungssystem (210) gespeicherten Werten eingelesen werden, sowie von Systemniveau-Farbkorrekturwerten Gebrauch gemacht wird.

13. Verfahren nach einem der vorgenannten Ansprüche, wobei die OLEDs mittels Stromquellen angetrieben werden und wobei in jedem OLED-Modulverarbeitungssystem (210) die Spannung über der Stromquelle (430) der schlechtesten OLED (420) mit einem vorgespeicherten Spannungs-Mindestschwellenwert verglichen wird, und wenn die Spannung niedriger als der Spannungs-Schwellenwert ist, eine Anpassung der elektrischen Betriebsspannung durchgeführt wird.

14. Verfahren nach Anspruch 13, wobei ein Alterungsfaktor für jedes Pixel ermittelt wird, um weitere Berechnungskorrekturen zu gestatten, wobei der Alterungsfaktor nach Durchführung der Anpassung der elektrischen Betriebsspannung ermittelt wird.

15. Verfahren nach einem der Ansprüche 1 bis 13, wobei in jedem OLED-Modulverarbeitungssystem (210) ein Alterungsfaktor für jede OLED (420) berechnet wird und wobei dieser Alterungsfaktor mit einem vorbestimmten Maximum verglichen wird und, wenn der errechnete Alterungsfaktor größer ist als das vorbestimmte Maximum, eine Anpassung der elektrischen Betriebsspannung für besagte OLED durchgeführt wird.

16. Großbildschirm-Leuchtanzeige, spezieller zur Verwirklichung des Verfahrens nach einem der Ansprüche 1 bis 15, wobei diese Anzeige (100) eine Anordnung von Anzeigekacheln (140) umfasst, die jede von einer Anordnung kleinerer Anzeigemodule (130) gebildet werden, wobei jedes Anzeigemodul (130) mindestens ein intelligentes Modulverarbeitungssystem (210) umfasst, und wobei jede Kachel (140) ein Kachelverarbeitungssystem (220) umfasst, das an die jeweiligen Module (130) gekoppelt und in Kommunikation mit jedem der Modulverarbeitungssysteme (220) ist, **dadurch gekennzeichnet, dass** die Modulverarbeitungssysteme (210) elektronische Mittel umfassen, die zur Ausführung des Verfahrens gleich welches der Ansprüche 1 bis 15 konfiguriert sind, und dass die Anzeige eine organische Leuchtdioden(OLED)-Anzeige ist, die Anzeigekacheln OLED-Anzeigekacheln sind, die Anzeigemodule OLED-Anzeigemodule sind, das Modulverarbeitungssystem ein OLED-Modulverarbeitungssystem ist.

17. Großbildschirm-Leuchtanzeige nach Anspruch 16, die so konfiguriert ist, dass die Größe und Abmessung durch Hinzufügen oder Entfernen von Kacheln verändert werden kann.

18. Großbildschirm-Leuchtanzeige nach Anspruch 16, die so konfiguriert ist, dass die Module austauschbar sind.

**Revendications**

1. Procédé pour afficher des images sur un grand écran à diodes électroluminescentes organiques, dans lequel il est fait usage d'un écran électroluminescent (100) comprenant une matrice de mosaïques d'affichage électroluminescentes (140) qui sont chacune constituées d'une matrice de modules d'affichage électroluminescents plus petits (130), chaque module d'affichage (130) comprenant plusieurs pixels électroluminescents, et dans lequel chaque module d'affichage (130) englobe un système de traitement de module intelligent (210), par lequel, dans le but d'afficher des images, des données concernant l'image à afficher, fourni par une unité de traitement générale, en d'autres termes un contrôleur de système, sont transmises à des systèmes de traitement de mosaïques (220) et, à partir de chaque système de traitement de mosaïque (220), en direction des modules respectifs (130), **caractérisé en ce que**, en état de marche, des mesures de couleurs sont prises, et **en ce que**, dans chaque système de traitement de module (210), le laps de temps qui s'est écoulé depuis les dernières prises de mesure de couleur est déterminé, ce laps de temps étant comparé à une valeur de consigne et dans le cas où ce laps de temps est supérieur à ladite valeur de consigne, une nouvelle mesure est prise, et **en ce que** l'écran est un écran à diodes électroluminescentes organiques (OLED), les mosaïques de l'écran sont des mosaïques d'écran OLED, les modules d'écran sont des modules d'écran OLED, les pixels sont des pixels OLED et le système de traitement de module est un système de traitement OLED.

2. Procédé selon la revendication 1, dans lequel ledit système de traitement de mosaïque (220) sont couplés en série, et en ce que les données de l'unité de traitement générale sont transmises via les systèmes de traitement de mosaïques successifs (220).

3. Procédé selon la revendication 1 ou 2, dans lequel l'unité de traitement générale procure des données RGB et des données de commande (CNTL), les données faisant partie des données RGB étant récoltées à chaque système de traitement de mosaïques individuel et/ou un chaque système de traitement de module individuel en fonction de signaux de commande générés au moyen desdites données de commande (CNTL).

4. Procédé selon les revendications 2 et 3, dans lequel chaque système de traitement de mosaïque (220) mémorise les données sérielles RGB pour l'image particulière qui correspond à la position physique de la mosaïque concernée (140) au sein de l'écran (100).

5. Procédé selon la revendication 4, dans lequel chaque système de traitement de mosaïque (220) analyse les données RGB reçues pour les transformer en paquets spécifiques associés aux systèmes de traitement de modules OLED correspondants (210).

6. Procédé selon l'une quelconque des revendications précédentes, dans lequel lesdits systèmes de traitement de modules OLED (210) prennent des décisions en ce qui concerne la quantité de courant à utiliser lors de l'entraînement de chaque pixel OLED dans un module (130).

7. Procédé selon la revendication 6, dans lequel lesdits systèmes de traitement de modules OLED (210) utilise des dispositifs de récolte des données et des algorithmes dans le but de prendre lesdites décisions.

8. Procédé selon l'une quelconque des revendications précédentes, dans lequel, dans les systèmes de traitement de modules (210), au moins le laps de temps pendant lequel chaque pixel individuel est « en fonction » est surveillé et est enregistré, les valeurs obtenues étant utilisées pour procéder à des réglages lors de l'entraînement des pixels OLED concernés dans un module (130).

9. Procédé selon l'une quelconque des revendications précédentes, dans lequel, dans les systèmes de traitement de module (210), au moins la quantité de courant qui est utilisé pour entraîner chaque OLED au cours du laps de temps pendant lequel chaque pixel individuel est « en fonction » est surveillé et est enregistré, les valeurs obtenues étant utilisées pour procéder à des réglages pour l'entraînement ultérieur des pixels OLED concernés dans un module (130).

10. Procédé selon l'une quelconque des revendications précédentes, dans lequel, en ce qui concerne l'entraînement des pixels (130), on procède à un ou plusieurs réglages au système de traitement de mosaïque correspondant (220) et/ou au système de traitement de module correspondant (210) lui-même.

11. Procédé selon l'une quelconque des revendications précédentes, dans lequel, lors de l'entraînement du ou des pixels OLED respectifs, des réglages sont effectués pour prendre en compte au moins un des facteurs suivants : l'âge, la température, la valeur gamma.

**12.** Procédé selon l'une quelconque des revendications précédentes, dans lequel, dans chaque système de traitement de module (210), plus particulièrement dans un préprocesseur (340) du système de traitement de module (210), il est fait usage de données de correction des couleurs existantes qui sont lues à partir de valeurs mémorisées dans le système de traitement de module (210, et à partir de valeurs de correction des couleurs au niveau du système.

**13.** Procédé selon l'une quelconque des revendications précédentes, dans lequel, les OLED sont entraînées au moyen de sources de courant, et en ce que, dans chaque système de traitement de module OLED (210), la tension qui traverse la source de courant (430) de la OLED (420) présentant la plus mauvaise qualité est comparée à une valeur de tension seuil minimale prémémorisée, et lorsque ladite tension est inférieure à la valeur de tension seuil, un réglage de la tension d'alimentation est mis en oeuvre.

**14.** Procédé selon la revendication 13, dans lequel on détermine facteurs de vieillissement pour chaque pixel, pour pouvoir procéder à des corrections de calculs ultérieures, ledit facteur de vieillissement étant déterminé après avoir procédé audit réglage de la tension d'alimentation.

**15.** Procédé selon l'une quelconque des revendications 1 à 13, dans lequel, dans chaque système de traitement de module OLED (210), un facteur de vieillissement est calculé pour chaque OLED (420), et en ce que ce facteur de vieillissement est comparé à une valeur maximale prédéterminée, et lorsque le facteur de vieillissement calculé est supérieur à la valeur maximale prédéterminée, un réglage de la tension d'alimentation pour ledit OLED est mis en oeuvre.

**16.** Grand écran à diodes électroluminescentes, plus particulièrement pour la mise en oeuvre du procédé selon l'une quelconque des revendications 1 à 15, par lequel cet écran (100) comprend une matrice de mosaïques d'affichage (140) qui sont chacune constituées d'une matrice de modules d'affichage plus petits (130), chaque module d'affichage (130) englobant un système de traitement de module intelligent (210), et par lequel chaque mosaïque (140) comprend un système de traitement de mosaïque (220) couplé aux modules respectifs (130) est mis en communication avec chacun des systèmes de traitement de modules (220), **caractérisé en ce que** les systèmes de traitement de modules (210) comprennent des moyens électroniques configurés pour la mise en oeuvre du procédé selon l'une quelconque des revendications 1 à 15, et **en ce que** l'écran est un écran à diodes électroluminescentes organiques (OLED), les mosaïques de l'écran sont des mosaïques d'écran OLED, les modules d'écran sont des modules d'écran OLED, les pixels sont des pixels OLED, le système de traitement de module est un système de traitement OLED.

**17.** Grand écran à diodes électroluminescentes selon la revendication 16, qui est configuré de telle sorte que la taille et la dimension peuvent être modifiées en ajoutant ou retirant des mosaïques.

**18.** Grand écran à diodes électroluminescentes selon revendication 16, qui est configuré de telle sorte que les modules sont remplaçables.

RGB DATA,
CNTL DATA

100

120

110

140a

| 130a | 130b | 130c | | 140b | | 140c |
| 130d | 130e | 130f | | | | |
| 130g | 130h | 130j | | | | |

| | 140d | | 140e | | 140f | |

| | 140g | | 140h | | 140j | |

*Fig.1*

RGB DATA,
CNTL DATA
(from previous tile 140)

Tile 140

220

| RGB$_A$ | Module 130a | Module 130b | Module 130c |
|---|---|---|---|
| CONTROL$_A$ | OLED module processing system 210a | OLED module processing system 210b | OLED module processing system 210c |
| MOD DATA$_A$ | | | |

RGB$_B$

CONTROL$_B$

MOD DATA$_B$

RGB$_C$

CONTROL$_C$

MOD DATA$_C$

| RGB$_D$ | Module 130d | Module 130e | Module 130f |
|---|---|---|---|
| CONTROL$_D$ | OLED module processing system 210d | OLED module processing system 210e | OLED module processing system 210f |
| MOD DATA$_D$ | | | |

RGB$_E$

CONTROL$_E$

MOD DATA$_E$

RGB$_F$

CONTROL$_F$

MOD DATA$_F$

| RGB$_G$ | Module 130g | Module 130h | Module 130j |
|---|---|---|---|
| CONTROL$_G$ | OLED module processing system 210g | OLED module processing system 210h | OLED module processing system 210j |
| MOD DATA$_G$ | | | |

RGB$_H$

CONTROL$_H$

MOD DATA$_H$

RGB$_J$

CONTROL$_J$

MOD DATA$_J$

RGB DATA,
CNTL DATA
(to next tile 140)

*Fig.2*

210

RGB(X) → **Pre-processor 340**

BANK CONTROL → **Bank switch controller 320**

V_OLED CONTROL → **OLED circuitry 310**

CCD CONTROL → **CCD controller 330**

PWM CONTROL

V_PRE-C CONTROL

DATA I/O

CONTROL(X) → **Module interface 370**

MODULE DATA(X)

DIGITAL VOLTAGE → **A/D converter 350**

ANALOG VOLTAGE

EEPROM I/O

**EEPROM 360**

TEMPERATURE DATA

**Temp-erature sensor 380**

*Fig.3*

*Fig.4*

500

Dark ambient
light gamma
curve 510

1 - A

530

X

Gamma correction
curve 560

530

S

540

X

A

Bright ambient
light gamma
curve 520

*Fig.5*

600

Start

Loading gamma in
pre-processor — 605

Reading existing
corrections — 610

Loading correction
for each pixel in
pre-processor — 615

Driving CCDs and
bank switches — 620

625 — Is time =
n*T ? — Yes

No

Reading
temperature — 630

635 — Is
temperature >
max? — No

Yes

Decreasing
light output — 640

Reading color
measurements from
EEPROM — 645

Changing
target color
temperature — 690

Reading target color
temperature — 650

Reading effective
OLED on time and
current — 655

Reading voltage
across current
sources — 660

665 — Is
voltage across I$_{SOURCE}$
≥ threshold? — No — Adjusting power
supply voltage

670

Yes

Determining aging
factor for each pixel — 675

Calculating
corrections — 680

Storing color
corrections in
EEPROM — 685

*Fig.6*

700

Start

Loading gamma in
pre-processor ⟍ 705

Reading existing
corrections ⟍ 710

Loading correction
for each pixel in
pre-processor ⟍ 715

Driving CCDs and
bank switches ⟍ 720

Is time =
n*T ? ⟍ 725    **Yes**

**No**

Reading
temperature ⟍ 730

Is
temperature >
max? ⟍ 735    **No**

**Yes**

Decreasing
light output ⟍ 740

Reading color
measurements from
EEPROM ⟍ 745

Changing
target color
temperature ⟍ 790

Reading target color
temperature ⟍ 750

Reading effective
OLED on time and
current ⟍ 755

Reading voltage
across current
sources ⟍ 760

Determining aging
factor for each pixel ⟍ 765

Is correction
range < max? ⟍ 770    **No**    Adjusting power
supply voltage

**Yes**    775

Calculating
corrections ⟍ 780

Storing color
corrections in
EEPROM ⟍ 785

*Fig.7*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0065432 A
- WO 9941732 A
- US 4833542 A
- US 5796376 A
- US 6498592 B
- DE 19950839